Europäisches Patentamt

European Patent Office

Office européen des brevets

(11) Publication number: **0 448 141 A1**

## EUROPEAN PATENT APPLICATION

(21) Application number: **91200360.5**

(22) Date of filing: **20.02.91**

(51) Int. Cl.⁵: **H01L 27/112, G11C 11/56**

(30) Priority: **27.02.90 IT 1950790**

(43) Date of publication of application:
**25.09.91 Bulletin 91/39**

(84) Designated Contracting States:
**DE FR GB SE**

(71) Applicant: **SGS-THOMSON
MICROELECTRONICS s.r.l.
Via C. Olivetti, 2
I-20041 Agrate Brianza Milano(IT)**

(72) Inventor: **Pascucci, Luigi
Via Ferrara, 26
I-20099 Sesto San Giovanni (Milano)(IT)**
Inventor: **Olivo, Marco
Via A. Maj, 22
I-24100 Bergamo(IT)**

(74) Representative: **Mittler, Enrico et al
c/o Marchi & Mittler s.r.l. Viale Lombardia, 20
I-20131 Milano(IT)**

(54) **Programming process suitable for defining at least four different current levels in an ROM memory cell.**

(57) The programming process relates to an ROM memory cell which comprises a substrate of semiconductor material (4) including regions of source (1) and drain (2) and a channel region (6) over which a gate (5) is superimposed. Programming is carried out by ionic implantation using a mask (7) for covering said gate (5) having a width which can vary among at least four different dimensions.

Fig.1

The present invention relates to a programming process suitable for defining at least four different current levels in an ROM memory cell.

Normally an ROM memory cell is constituted by an MOS transistor, which may be programmed during manufacture so as to generate two different current levels, corresponding logically to the conditions 0 and 1.

As is known, such programing, carried out after the usual steps of formation of the control gate and definition of source and drain regions on both sides of the channel region under the gate, consists in the implantation of a dopant which has the effect of moving the cell's voltage threshold, that is the transistor's firing threshold, so as to accomplish a conductivity that is less than the original one.

Such implantation is preceded by a masking operation which extends along the entire width of the gate.

The object of the present invention is to accomplish a planarization process with which it is possible to obtain ROM memory cells with more than two current levels.

According to the invention such object is attained with a programming process for an ROM memory cell constituted by a substrate of semiconductor material including regions of source and drain and a channel region between them, over which a gate is superimposed, comprising the application of a mask on said gate and an implantation of dopant suitable for varying the cell's conductivity, characterized in that said mask has a width which can vary among at least four different dimensions.

In this way, by modulating the width of the mask, it is possible to vary the masked part of the gate and so to set different conduction levels of the cell and thus different levels of current delivered.

The features of the present invention shall be made more evident by an embodiment illustrated as a non-limiting example in the enclosed drawings, wherein:

Fig. 1 illustrates a top plan view of an ROM memory cell with its gate masked centrally for 1/3 of its width;

Fig. 2 illustrates a sectional view of the ROM memory cell illustrated in Fig. 1;

Fig. 3 illustrates a top plan view of another ROM memory cell with its gate masked centrally for 2/3 of its width;

Fig.s 4, 5 illustrate top plan views of further ROM memory cells masked on one side so as to leave uncovered a central region equal to 1/3 and 2/3 of its width, respectively.

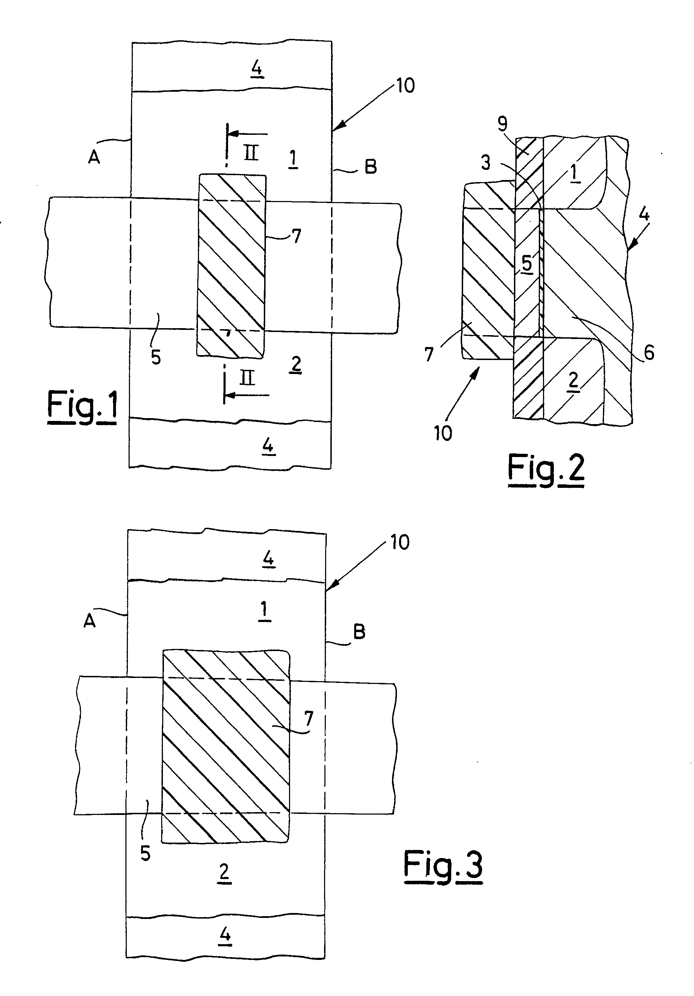

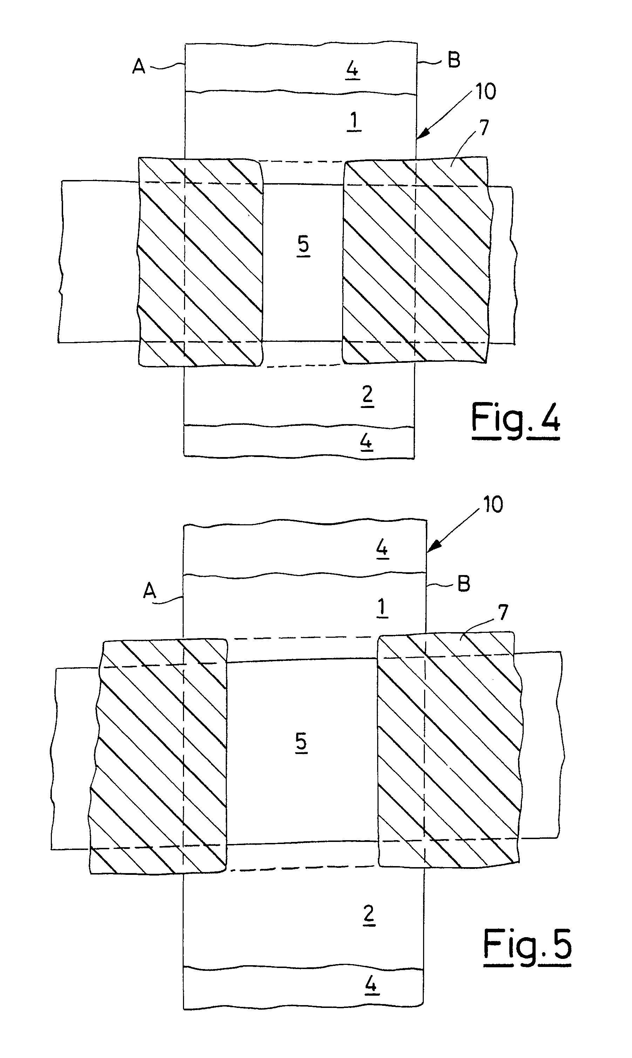

With reference to Fig.s 1 and 2, a cell 10 defined between the parallel lines A and B, comprises a substrate of semiconductor material 4 on the surface of which there are obtained regions of source 1 and drain 2, covered by oxide 9 (not shown for the sake of simplicity in Fig. 1), between which there is defined a channel region 6 over which there is superimposed a gate 5 with gate oxide 3.

Before the implantation of the programming dopant, a mask 7, extending for one third of the width of the cell, is superimposed over the central part of gate 5, as shown in Fig. 1. In this way the implantation of dopant affects the remaining two thirds of the width of the cell, thus determining a third current level, which is in addition to those corresponding to the masking of the entire gate 5 or of no part of it. It should be noted that, thanks to the central position of the mask, the current level is independent of any misalignments of the mask itself.

With reference to Fig.s 4, 5, altogether similar to Fig.s 1 and 3, such mask 7 completely covers the gate 5 with the exception of a central strip equal to one and two thirds of its width, respectively. This is a different way of obtaining the third and fourth current level mentioned above. In this case again the independence of any misalignments of the mask is ensured.

Both in the version of Fig.s 1 and 3 and in that of Fig.s 4 and 5, there are thus four different values of current which can be supplied with the same bias: unmasked cell (maximum current), wholly masked cell (minimum current), two intermediate masking values (two intermediate current values). These four current values correspond to four possible combinations of two bits of information, that is, the cases 00, 01, 10, 11.

Naturally the width of the control gate's covering mask can be selected at will, thus defining different cell currents.

**Claims**

1. Programming process for an ROM memory cell constituted by a substrate of semiconductor material (4) including regions of source (1) and drain (2) and a channel region (6) between them, over which a gate (5) is superimposed, comprising the application of a mask (7) over said gate (5) and an implantation of dopant suitable for varying the cell's conductivity, characterized in that said mask (7) has a width which can vary among at least four different dimensions.

2. Process according to claim 1, characterised in that said mask (7) is superimposed centrally over gate (5) and essentially extends for 1/3 of its width.

3. Process according to claim 1, characterized in that said mask (7) is superimposed centrally over gate (5) and essentially extends for 2/3 of its width.

4. Process according to claim 1, characterised in that said mask covers said gate (5) entirely except for a central strip equal to 1/3 of its width.

5. Process according to claim 1, characterised in that said mask covers said gate (5) entirely except for a central strip equal to 2/3 of its width.

Fig.1

Fig.2

Fig.3

A ⌒ B

4

10

1

7

5

2

4

## Fig.4

10

4

A ⌒ B

1

7

5

2

4

## Fig.5

European
Patent Office

EUROPEAN SEARCH
REPORT

Application Number

EP 91 20 0360

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 119 729  (FUJITSU LTD)<br>* Claims 1-2,9-11; page 8, lines 12-24;; page 10, line 16 - page 11, line 18; figures 3A-3B * | 1 | H 01 L 27/112<br>G 11 C 11/56 |
| A | | 2-3 | |
| X | IBM TECHNICAL DISCLOSURE BULLETIN, vol. 23, no. 10, March 1981, page 4461, Armonk, New York, US; K. BERN-STEIN et al.: "Four-state memory cell for read-only storage",<br>* Entire text; figures * | 1 | |
| A | IDEM | 2-5 | |

TECHNICAL FIELDS
SEARCHED (Int. Cl.5)

H 01 L 27
G 11 C

The present search report has been drawn up for all claims

| Place of search | Date of completion of search | Examiner |
|---|---|---|
| The Hague | 27 June 91 | FRANSEN L.J.L. |

CATEGORY OF CITED DOCUMENTS
X : particularly relevant if taken alone
Y : particularly relevant if combined with another
document of the same catagory
A : technological background
O : non-written disclosure
P : intermediate document
T : theory or principle underlying the invention

E : earlier patent document, but published on, or after
the filing date
D : document cited in the application
L : document cited for other reasons

&: member of the same patent family, corresponding
document